# EUROPEAN PATENT SPECIFICATION

(11) **EP 4 156 255 B1**
(45) Date of publication and mention of the grant of the patent: **09.12.2026**
(21) Application number: 22191777.6
(22) Date of filing: 23.08.2022
(51) Int. Cl.: H01F 17/00, H05K 1/16, H10D 1/20, H10W 70/63, H10W 70/65, H10W 70/685, H05K 3/46

(54) **LOCALIZED HIGH PERMEABILITY MAGNETIC REGIONS IN GLASS PATCH FOR ENHANCED POWER DELIVERY**
LOKALISIERTE HOCHDURCHLÄSSIGE MAGNETISCHE REGIONEN IN EINEM GLASPATCH ZUR VERBESSERTEN STROMVERSORGUNG
RÉGIONS MAGNÉTIQUES LOCALISÉES À HAUTE PERMÉABILITÉ DANS UN TIMBRE EN VERRE POUR UNE DISTRIBUTION D'ÉNERGIE AMÉLIORÉE

(30) Priority: 23.09.2021 US 202117482747
(43) Date of publication of application: 29.03.2023
(73) Proprietor: Intel Corporation, Santa Clara, CA 95054 (US)
(72) Inventor: PIETAMBARAM, Srinivas V., Chandler, 85297 (US); IBRAHIM, Tarek A., Mesa, 85203 (US); COLLINS, Andrew, Chandler, 85249 (US)
(74) Representative: 2SPL Patentanwälte PartG mbB

(56) References cited:
- US-A1- 2013 342 301
- US-A1- 2019 198 436
- US-A1- 2019 350 090
- US-A1- 2020 005 994
- US-A1- 2021 273 036

## Description

### TECHNICAL FIELD

Embodiments of the present disclosure relate to electronic packages, and more particularly to electronic packages that include a glass core with magnetic inductor structures.

### BACKGROUND

To achieve high efficiency power delivery schemes for electronic packages, it is important to design and incorporate inductors with a high inductance density and a high Q factor to improve power conversion. Current solutions use air core inductors (ACIs), surface mounted or embedded discrete inductor modules, and architectures where plated through holes (PTHs) are filled with high permeability magnetic materials to achieve high power conversion efficiency. Such solutions can be implemented in thick server and client products, and have demonstrated significant improvements in power efficiency. All of these solutions are implemented on organic core substrates. Organic core substrates are limited in the ability to scale to larger form factors or to finer features.

Glass cores provide improved dimensional stability and flatness. Such properties enable the scaling to finer feature sizes and larger form factors. However, glass core substrates are limited in thickness due to limited metallization capabilities for through glass via (TGV) architectures. Although high aspect ratio TGV openings are possible in glass utilizing existing technologies (e.g., laser induced deep etching), filling the TGV with copper and/or plugging with magnetic material is currently limited. Particularly, glass cores thicker than approximately 500µm are considered high risk for copper filling and magnetic plugging to form magnetic inductor structures. As such, high efficiency in-built inductors cannot currently be fabricated on thick glass cores.

US 2019/198436 A1 and US 2013/342301 A1 disclose a package structure comprising a core and build up layers above and under the core. In a cavity of the build up layers under the core a magnetic material may be formed in an opening.

### BRIEF DESCRIPTION OF THE DRAWINGS

Figure 1 is a cross-sectional illustration of an electronic package with a glass core that includes in-built inductors, in accordance with an embodiment.
Figures 2A-2C are illustrations of inductors formed through a magnetic plug, in accordance with an embodiment.
Figures 3A-3C are illustration of inductors formed around a magnetic plug, in accordance with an embodiment.
Figures 4A-4M are cross-sectional illustrations of a process for forming an electronic package with a glass core that includes in-built inductors, in accordance with an embodiment.
Figure 5A is a cross-sectional illustration of a glass patch with inductors embedded in buildup layers over the glass layer, in accordance with an embodiment.
Figure 5B is a cross-sectional illustration of a glass patch with inductors embedded in buildup layers over the glass core with a bridge that includes through substrate vias, in accordance with an embodiment.
Figure 5C is a cross-sectional illustration of a glass patch with in-built inductors that is coupled to a package substrate, in accordance with an embodiment.
Figures 6A-6D are illustrations of in-built inductor architectures, in accordance with an embodiment.
Figures 7A-7Q are cross-sectional illustrations of a process for forming an electronic package with a glass patch that includes in-built inductors, in accordance with an embodiment.
Figure 8 is a schematic of a computing device built in accordance with an embodiment.

### EMBODIMENTS OF THE PRESENT DISCLOSURE

Described herein are electronic packages that include a glass core with magnetic inductor structures, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, glass cores are a potential technology advancement that will enable scaling to smaller feature sizes and/or to larger form factors. However, existing technologies limit the ability to form in-built inductor architectures in the glass core. Accordingly embodiments disclosed herein include processes and architectures for enabling in-built inductors in thick glass core layers. In an embodiment, the process may include creating cavities through the glass and filling the cavity with a high permeability magnetic paste which is cured to form a block of magnetic material. An inductor is created by looping conductive traces and vias around and/or through the magnetic material. Since the glass is high temperature amenable, the magnetic pastes can be sintered at higher temperatures to achieve permeabilities that can be much higher compared to similar architectures formed on organic cores.

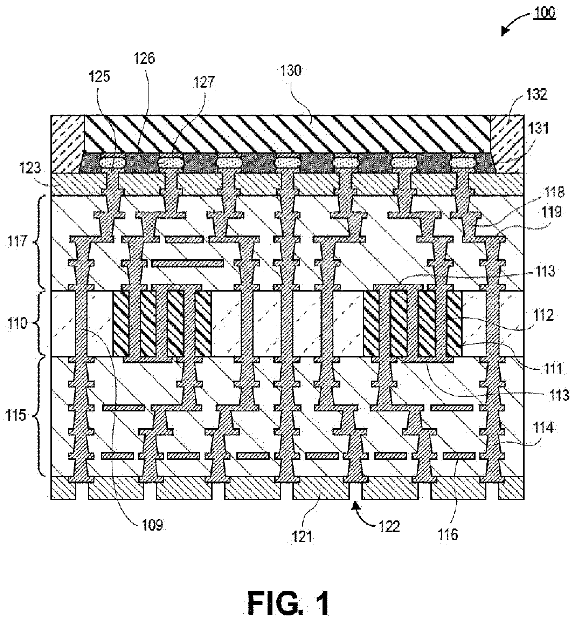

Referring now to Figure 1, a cross-sectional illustration of an electronic package 100 is shown, in accordance with an embodiment. In an embodiment, the electronic package 100 comprises a core 110, buildup layers 117 above the core 110, and buildup layers 115 below the core 110. In an embodiment, the core 110 comprises glass. The core 110 may sometimes be referred to as a glass core 110. In an embodiment, the core 110 may have a thickness that is greater than approximately 100µm. In other embodiments, the core 110 may have a thickness that is greater than approximately 500µm. As used herein "approximately" may refer to a range of values within 10% of the stated value. For example, approximately 100µm may refer to a range between 90µm and 110µm.

In an embodiment, the buildup layers 117 and 115 may be standard dielectric materials. The individual layers may be laminated over each other. Additionally, conductive routing may be provided in the buildup layers 117 and 115. For example, traces 119 and vias 118 are provided in the buildup layers 117 and traces 116 and vias 114 are provided in the buildup layers 115. In an embodiment, a solder resist 121 is provided below the buildup layers 115. Solder resist openings 122 may be provided through the solder resist 121 to allow coupling with mid-level interconnects (MLIs) or second level interconnects (SLIs). In an embodiment, a solder resist 123 is provided above the buildup layers 117. First level interconnect (FLI) pads 125 may be over the solder resist 123. Solder 126 couples the FLI pads 125 to die pads 127 on a die 130. In an embodiment, the FLIs are surrounded by an underfill 131. A mold layer 132 may surround the die 130. In an embodiment, the die 130 may be any type of die (e.g., a processor, a graphics processor, a memory die, or the like). Additionally, multiple dies may be coupled to the buildup layers 117.

In an embodiment, the core 110 may comprise through core vias 109. The through core vias 109 may electrically couple the buildup layers 117 to the buildup layers 115. In an embodiment, the through core vias 109 may be formed with a laser drilling process in some embodiments. In an embodiment, the core 110 may also comprise magnetic plugs 111. The magnetic plugs 111 may be a magnetic material that is originally deposited as a paste or film, and which is cured to form the magnetic plugs 111. Since the core 110 can withstand high temperatures, the magnetic material may be a material that is sintered or otherwise cured at a high temperature. This allows for magnetic plugs 111 with higher permeabilities. For example, the magnetic plugs 111 may include ferrite filler particles. Ferrite particles provide intrinsically higher permeabilities, but require higher annealing temperatures.

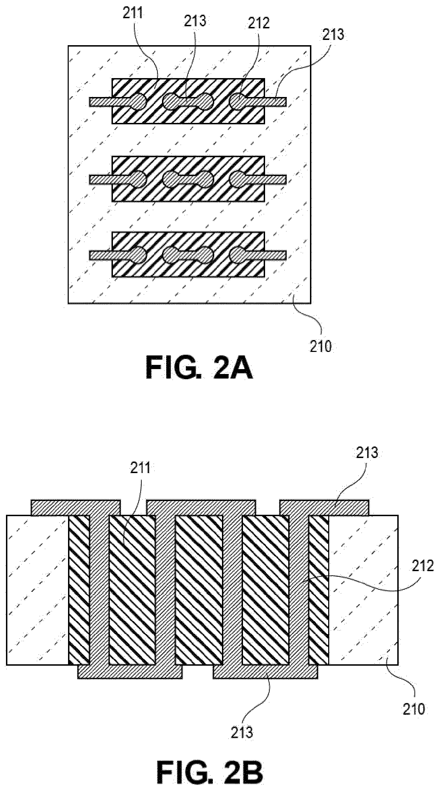

In an embodiment, conductive traces/vias wrap around and/or pass through the magnetic plugs 111. For example, as shown in Figure 1, vias 112 pass through the thickness of the magnetic plugs 111. Conductive traces 113 over the magnetic plugs 111 may couple together vias 112 in order to provide conductive loops around and/or through the magnetic plugs 111 to form inductors within the core 110. More detailed illustrations of the inductors in accordance with various embodiments are shown in Figures 2A-3C.

Referring now to Figure 2A, a plan view illustration of inductors in a core 210 are shown, in accordance with an embodiment. In an embodiment, the core 210 may be substantially similar to the core 110 described above. That is, the core 210 may comprise glass. In an embodiment, a plurality of magnetic plugs 211 may be provided in the core 210. As shown, a plurality of vias 212 are formed through the magnetic plugs 211, and the vias 212 may be coupled together by traces 213.

Referring now to Figure 2B, a cross-sectional illustration of the core 210 and one of the magnetic plugs 211 is shown, in accordance with an embodiment. As shown, the vias 212 pass through a thickness of the magnetic plug 211. The vias 212 are coupled together by traces 213 that are formed over and in direct contact with the magnetic plug 211 and the core 210.

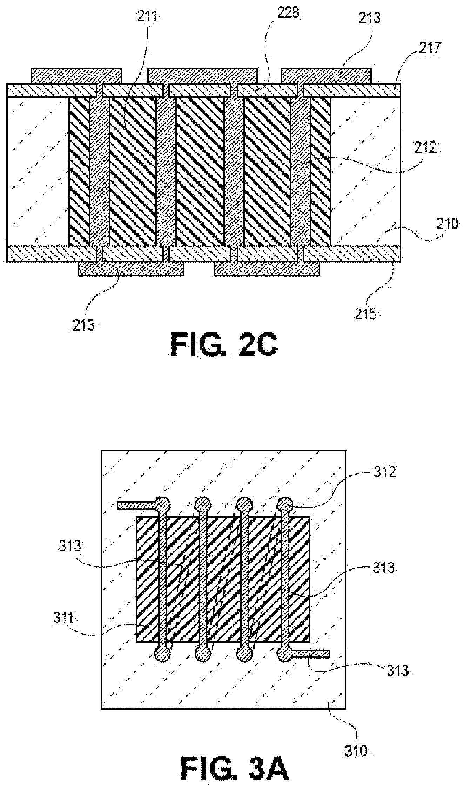

Referring now to Figure 2C, a cross-sectional illustration of the core 210 and one of the magnetic plugs 211 is shown, in accordance with an additional embodiment. Instead of forming the conductive traces 213 in direct contact with the magnetic plug 211 and the core 210, a layer of the buildup layers 217 and 215 are formed directly over the magnetic plug 211 and the core 210. In an embodiment, vias 228 may pass through the buildup layers 217 and 215 in order to couple the vias 212 to the traces 213.

Referring now to Figure 3A, a plan view illustration of an inductor around a magnetic plug 311 in a core 310 is shown, in accordance with an embodiment. The inductor in Figure 3A forms loops around the magnetic plug 311 without vias 312 passing through the magnetic plug 311. Instead, the vias 312 are adjacent to the magnetic plug 311. The traces 313 pass over and below the magnetic plug 311.

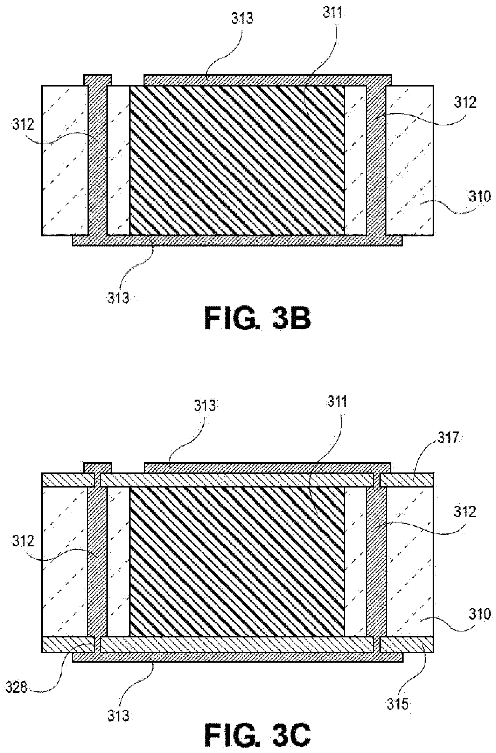

Referring now to Figure 3B, a cross-sectional illustration of the core 310 and the magnetic plug 311 is shown, in accordance with an embodiment. As shown, an inductive loop is provided around the magnetic plug 311. The vias 312 pass through the core 310 adjacent to the magnetic plug 311. The traces 313 provide lateral connections between the vias 312, and the traces 313 pass over the magnetic plug 311. In the illustrated embodiment, the traces 313 are in direct contact with the magnetic plug 311 and the core 310.

Referring now to Figure 3C, a cross-sectional illustration of the inductor around the magnetic plug 311 is shown, in accordance with an additional embodiment. The inductor in Figure 3C is substantially similar to the inductor in Figure 3B with the addition of buildup layers 317 and 315 over the magnetic plug 311 and the core 310. As such, the conductive traces 313 are not in direct contact with the magnetic plug 311 or the core 310. Vias 328 may pass through the buildup layers 317 and 315 in order to couple the vias 312 to the conductive traces 313.

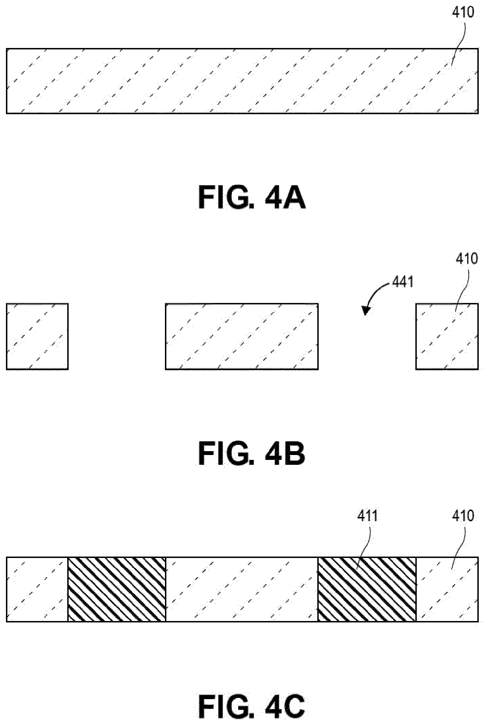

Referring now to Figures 4A-4M, a series of cross-sectional illustrations depicting a process for forming an electronic package with a glass core and in-built inductors is shown, in accordance with an embodiment. In the illustrated embodiment, a single unit is formed. However, it is to be appreciated that the form factor of the core may be panel level, quarter panel level, or any other form factor. That is, parallel processing of multiple units is possible in some embodiments.

Referring now to Figure 4A, a cross-sectional illustration of a core 410 is shown, in accordance with an embodiment. In an embodiment, the core 410 may comprise glass. That is, core 410 may be a glass core. In an embodiment, the core 410 has a thickness that is approximately 100µm or greater, or approximately 500µm or greater. In an embodiment, a coefficient of thermal expansion (CTE) of the core 410 may be approximately 4 or below.

Referring now to Figure 4B, a cross-sectional illustration of the core 410 after cavities 441 are formed through the core 410 is shown, in accordance with an embodiment. In an embodiment, the cavities 441 may be formed with a crack-free laser-based cutting process. In the illustrated embodiment, the cavities 441 have substantially vertical sidewalls. However, the sidewalls may be tapered in some embodiments.

Referring now to Figure 4C, a cross-sectional illustration of the core after a magnetic material is disposed in the cavities 441 is shown, in accordance with an embodiment. In an embodiment, the magnetic material may be a paste or a film. In some embodiments, a protective film or a support panel is attached to the back side of the core 410 while the magnetic material is disposed into the cavities 441. After disposing the magnetic material in the cavities 441, the magnetic material may be cured to form a magnetic plug 411. In some embodiments, the curing process shrinks the magnetic plug 411. In such embodiments, a second paste printing or film lamination is implemented in order to refill the cavities 441. In an embodiment, the magnetic material may be a high permeability magnetic material. For example, the magnetic material may comprise ferrite filler particles. A high temperature cure (e.g., sintering) is possible since the core 410 can withstand higher temperatures compared to traditional organic core materials. After curing, excess magnetic material outside of the cavities 441 may be removed with a polishing or grinding process. When a support panel or film is used, the support panel or film can be removed after the magnetic plug 411 is fully cured.

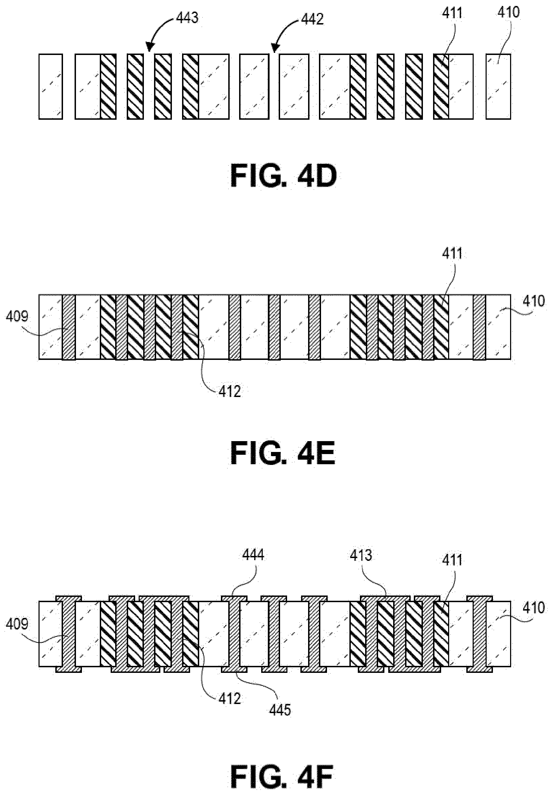

Referring now to Figure 4D, a cross-sectional illustration of the core 410 after via openings 443 and 442 are formed through a thickness of the magnetic plug 411 and the core 410 is shown, in accordance with an embodiment. In an embodiment, the via openings 442 are formed through the core 410. The via openings 442 may be formed with a laser drilling process. In an embodiment, the sidewalls of the via openings 442 are shown as being vertical, but in some embodiments, the sidewalls of the via openings 442 may be tapered. In an embodiment, the via openings 443 are formed through the magnetic plug 411. In an embodiment, the via openings 443 may be formed with a process different than the process used to form the via openings 442. For example, the via openings 442 may be made with a mechanical drilling process or an etching process.

Referring now to Figure 4E, a cross-sectional illustration of the core 410 after the via openings 442 and 443 are filled with conductive material to form vias 409 and 412 is shown, in accordance with an embodiment. In an embodiment, the conductive material (e.g., copper) can be plated with any suitable plating process. In an embodiment, excess material over the core 410 or the magnetic plug 411 may be polished back so that vias 412 are flush with the top and bottom surfaces of the magnetic plug 411, and the vias 409 are flush with the top and bottom surfaces of the core 410.

Referring now to Figure 4F, a cross-sectional illustration of the core 410 after pads 444/445 and traces 413 are formed over the vias 409 and 412 is shown, in accordance with an embodiment. In an embodiment, pads 444 are provided over the top surfaces of the vias 409 and pads 445 are provided over the bottom surfaces of the vias 409. In an embodiment, conductive traces 413 are provided over the magnetic plug 411. The traces 413 electrically couple together vias 412 that pass through magnetic plug 411. As such conductive loops are provided through and around the magnetic plug 411 to provide an in-built inductor. In an embodiment, the pads 444, 445, and traces 413 may be formed with a standard semi-additive process (SAP).

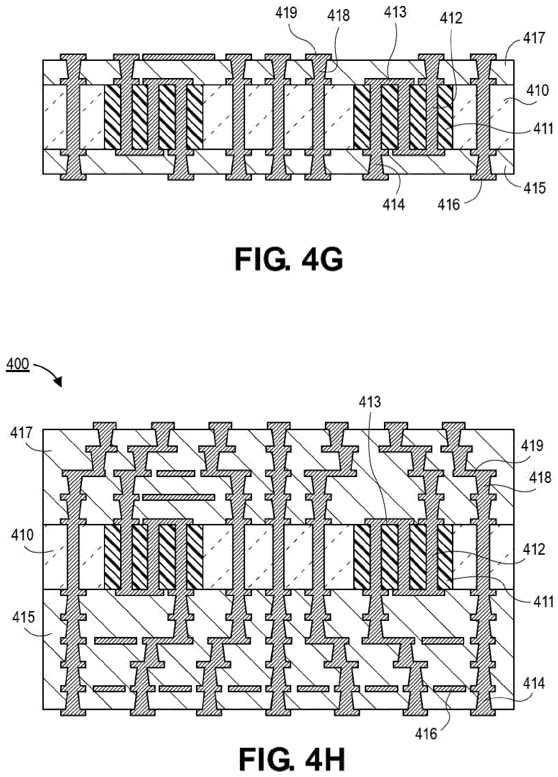

Referring now to Figure 4G, a cross-sectional illustration of the core 410 after buildup layers 417 and 415 are formed above and below the core 410 is shown, in accordance with an embodiment. In an embodiment, the buildup layers 417 may include vias 418 and pads/traces 419, and the buildup layers 415 may include vias 414 and pads/traces 416. The buildup layers 417 and 415 may be formed with typical package substrate processes. For example, the dielectric buildup layers 417 and 415 may be laminated over the core 410. Laser drilling may be used to form the via openings, and SAP techniques may be used to form the conductive features.

Referring now to Figure 4H, a cross-sectional illustration of an electronic package 400 is shown, in accordance with an embodiment. The electronic package 400 may be formed from the core 410 shown in Figure 4G. Particularly, dielectric lamination and SAP techniques may be continued to provide any desired number of buildup layers 417 and 415. In an embodiment, the topside buildup layers 417 may be a fan-in electrical structure, and the backside layers 415 may include a fan-out electrical structure.

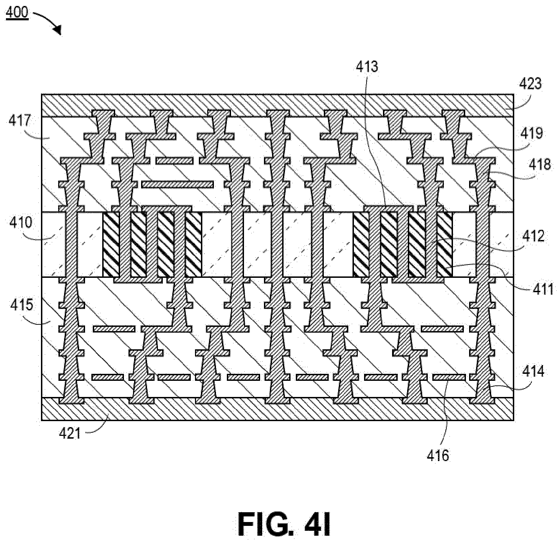

Referring now to Figure 4I, a cross-sectional illustration of the electronic package 400 after solder resist layers 423 and 421 are disposed over the buildup layers 417 and 415 is shown, in accordance with an embodiment. In an embodiment, the solder resist layers 423 and 421 may be disposed with a lamination process. In some embodiments, the solder resist layers 423 and 421 may be cured.

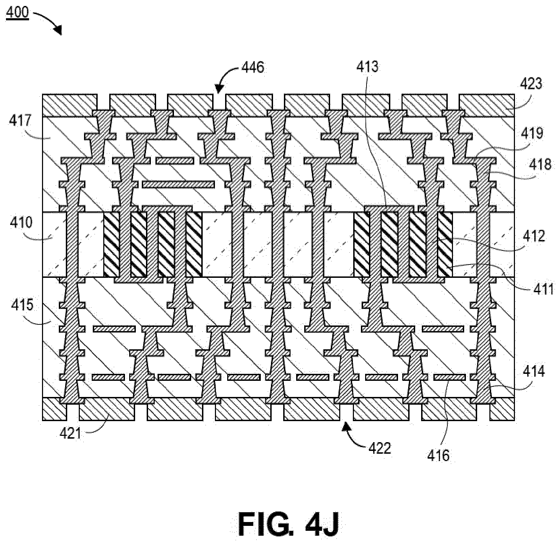

Referring now to Figure 4J, a cross-sectional illustration of the electronic package 400 after the solder resists 423 and 421 are patterned to form solder resist openings 446 and 422 is shown, in accordance with an embodiment. In an embodiment, the solder resist openings 446 and 422 may be formed with any suitable patterning process. In an embodiment, the solder resist openings 446 and 422 may be formed with a lithography and patterning process. In other embodiments, the solder resist openings 446 and 422 may be formed with laser drilling processes.

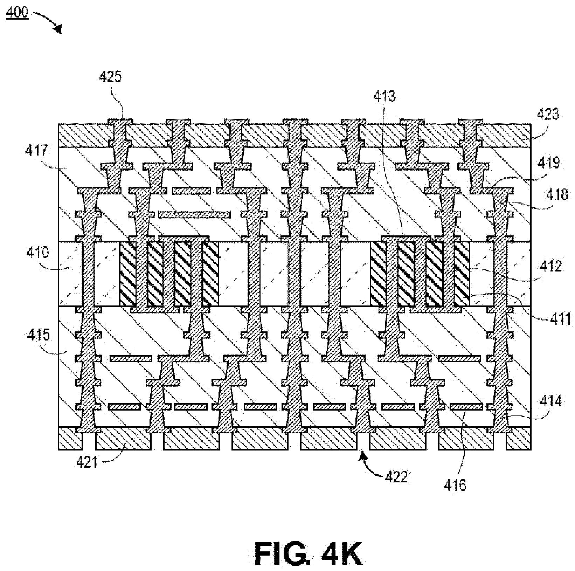

Referring now to Figure 4K, a cross-sectional illustration of the electronic package 400 after plating the FLI pads 425 is shown, in accordance with an embodiment. In an embodiment, the FLI pads 425 may be formed with an SAP technique in some embodiments. The FLI pads 425 may further be plated with a surface finish (not shown). In some embodiments, a solder may also be plated over the FLI pads 425. In an embodiment, a surface finish (not shown) may also be plated over the pads exposed by the solder resist openings 422 on the backside surface of the electronic package 400.

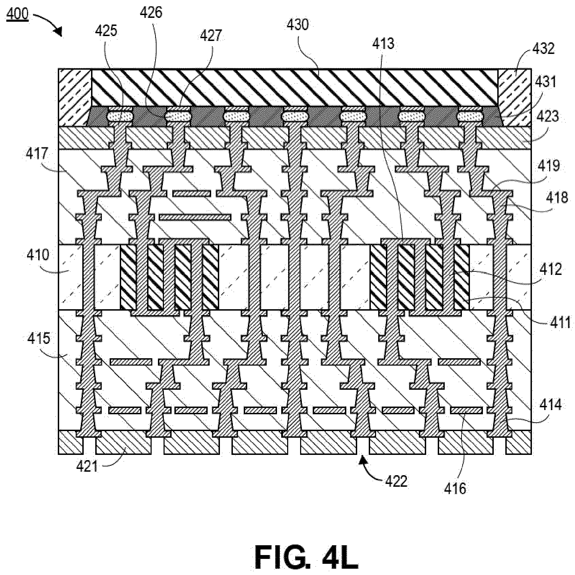

Referring now to Figure 4L, a cross-sectional illustration of the electronic package 400 after a die 430 is coupled to the FLI pads 425 is shown, in accordance with an embodiment. As shown, solder 426 may couple the FLI pads 425 to die pads 427. The die 430 may be attached with a thermocompression bonding (TCB) process in some embodiments. In an embodiment, the solder 426 may be surrounded by an underfill 431. A mold layer 432 may also be provided around the die 430 in some embodiments. A backside surface of the die 430 remains exposed (e.g., to allow for coupling to a thermal solution (not shown)).

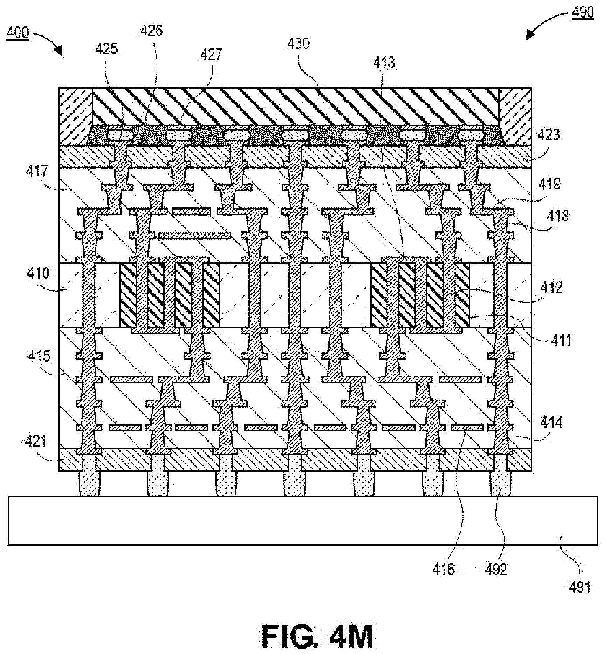

Referring now to Figure 4M, a cross-sectional illustration of an electronic system 490 is shown, in accordance with an embodiment. In an embodiment, the electronic system 490 comprises an electronic package 400 that is similar to the electronic package 400 in Figure 4L. Additionally, the electronic system 490 comprises a board 491, such as a printed circuit board (PCB). In an embodiment, the board 491 is coupled to the electronic package 400 by second level interconnects (SLIs) 492. In an embodiment, the SLIs 492 are solder balls, but it is to be appreciated that any SLI architecture may be used.

Embodiments described herein also include architectures that may be described as glass patches. In a glass patch architecture, a glass substrate may have overlying dielectric layers with vertical pillars. Bridge dies may be embedded within the dielectric layers to provide high density interconnects between overlying dies. In such architectures, the glass patch may be coupled to a traditional package substrate using MLIs. The inductors for such an electronic package are typically included in the traditional package substrate. As such, the inductors have a relatively long path to the overlying dies.

Accordingly, embodiments disclosed herein include glass patch architectures with in-built inductors formed in the glass patch. Moving the inductors to the glass patch allows for more efficient power delivery to the IO tiles over the glass patch. In an embodiment, the in-built inductors are formed in the buildup layers disposed over the glass core.

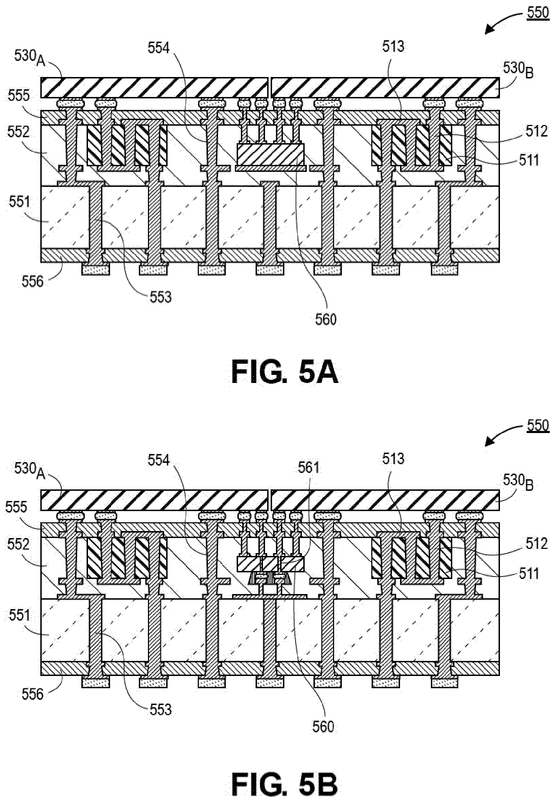

Referring now to Figure 5A, a cross-sectional illustration of a glass patch 550 is shown, in accordance with an embodiment. In an embodiment, the glass patch 550 may comprise a core 551. Particularly, the core 551 may comprise glass. Vias 553 may pass through the core 551. In an embodiment, buildup layers 552 may be provided over the top surface of the core 551. In an embodiment, the buildup layers 552 may be a plurality of layers that are laminated over each other. In an embodiment, vias 554 may pass through the buildup layers 552. Solder resist layer 556 may be provided below the core 551 and solder resist layer 555 may be provided above the buildup layers 552.

In an embodiment, one or more bridge dies 560 may be embedded in the buildup layers 552. The bridge die 560 provides communicative coupling between a first die 530_{A} and a second die 530_{B}. For example, FLIs, vias, and pads provide electrical coupling between the dies 530 and the bridge 560. In the particular embodiment shown in Figure 5A, the bridge die 560 is a passive device.

In an embodiment, in-built inductors may also be provided in the buildup layers 552. The in-built inductors may comprise a magnetic plug 511. Conductive routing may be formed around and/or through the magnetic plug 511. For example, vias 512 may pass through the magnetic plug 511 and traces 513 couple together the vias 512 to provide loops around the magnetic plug 511. In an embodiment, the magnetic plug 511 may be a magnetic paste or film that is cured to provide a magnetic material with a higher permeability. As such, high quality inductors can be formed within the glass patch 550.

Referring now to Figure 5B, a cross-sectional illustration of a glass patch 550 is shown, in accordance with an additional embodiment. The glass patch 550 in Figure 5B may be substantially similar to the glass patch 550 in Figure 5A, with the exception of the configuration of the bridge die 560. Instead of being a passive device, the bridge die 560 may be an active component (e.g., comprising transistors or the like). In some embodiments, the bridge die 560 may comprise through silicon vias (TSVs) 561 and be coupled to an underlying through glass via 553 through interconnects (e.g., solder, pads, vias, etc.) between the bridge die 560 and the core 551.

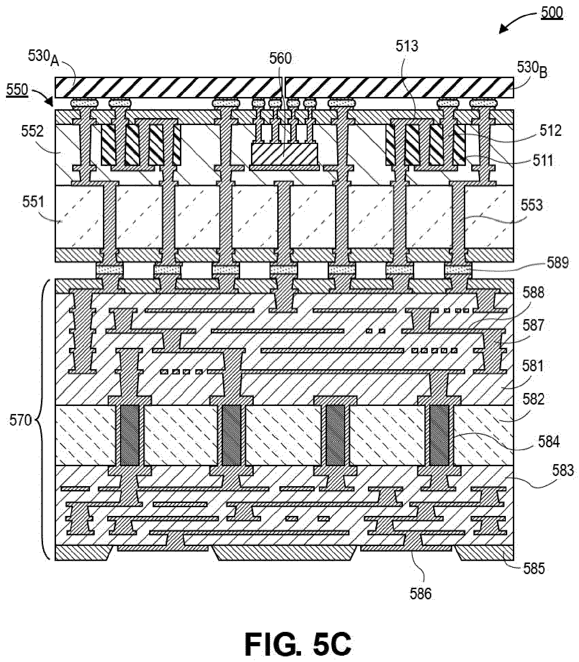

Referring now to Figure 5C, a cross-sectional illustration of an electronic package 500 is shown, in accordance with an embodiment. In an embodiment, the electronic package 500 comprises a glass patch 550 that is coupled to package substrate 570. In an embodiment, the glass patch 550 may be substantially similar to the glass patch 550 in Figure 5A. Though, it is to be appreciated that a glass patch 550 similar to the one shown in Figure 5B may also be used in the electronic package 500. In an embodiment, the glass patch 550 is coupled to the package substrate 570 by MLIs 589. The MLIs 589 may be solder balls or the like.

In an embodiment, the package substrate 570 may be a typical package substrate. In some embodiments, the package substrate 570 comprises a core 582. The core 582 may be an organic core in some embodiments. Through core vias 584 may be provided through the core 582. The through core vias 584 may be plated through holes or the like. In an embodiment, buildup layers 581 are over the core 582, and buildup layers 583 may be below the core 582. Pads/traces 588 and vias 587 provide electrical routing in the buildup layers 581 and 583. SLI pads 586 may be exposed through a solder resist 585 at the bottom of the package substrate 570.

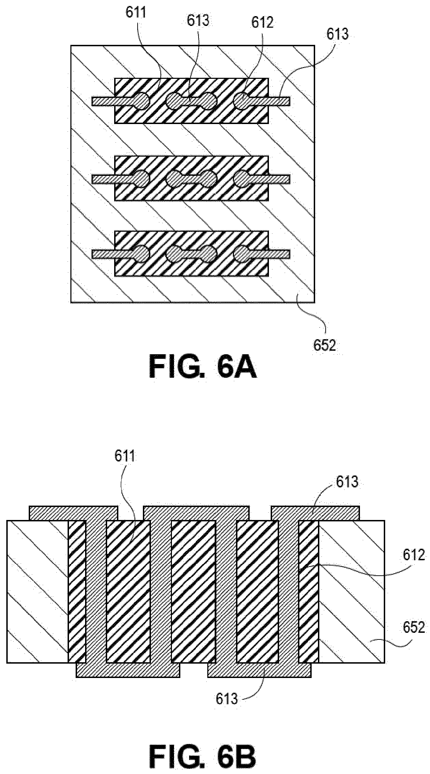

Referring now to Figures 6A-6D, illustrations depicting the structure of the in-built inductors are shown, in accordance with various embodiments. In some embodiments, the in-built inductors pass through the magnetic plug 611, while in other embodiments, the in-built inductors wrap around the outside of the magnetic plug 611. The inductors shown in Figures 6A-6D may be integrated into glass patches similar to those shown in Figures 5A-5C.

Referring now to Figure 6A, a plan view illustration of inductors in a buildup layer 652 is shown, in accordance with an embodiment. In an embodiment, the buildup layer 652 may be substantially similar to buildup layer 552 described above. That is, the buildup layer 652 may comprise one or more dielectric layers that are laminated over each other. In an embodiment, a plurality of magnetic plugs 611 may be provided in the buildup layers 652. As shown, a plurality of vias 612 are formed through the magnetic plugs 611, and the vias 612 may be coupled together by traces 613.

Referring now to Figure 6B, a cross-sectional illustration of the buildup layers 652 and one of the magnetic plugs 611 is shown, in accordance with an embodiment. As shown, the vias 612 pass through a thickness of the magnetic plug 611. The vias 612 are coupled together by traces 613 that are formed over and in direct contact with the magnetic plug 611 and the buildup layer 652. However, in some embodiments, a dielectric layer may separate the traces 613 from the magnetic plug 611.

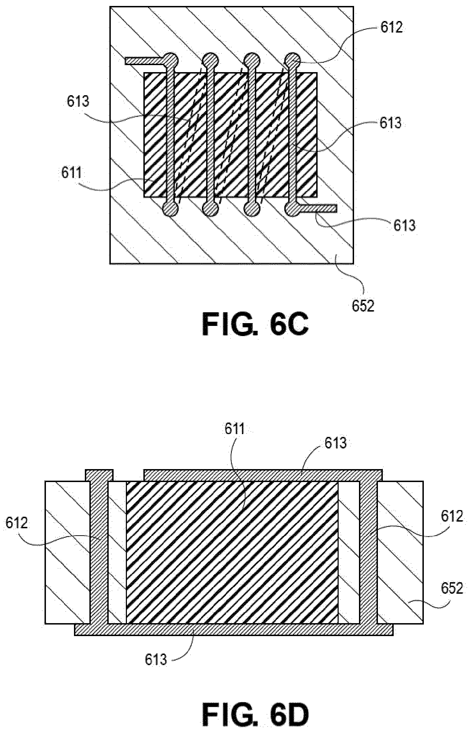

Referring now to Figure 6C, a plan view illustration of an inductor around a magnetic plug 611 in a buildup layer 652 is shown, in accordance with an embodiment. The inductor in Figure 6C forms loops around the magnetic plug 611 without vias 612 passing through the magnetic plug 611. Instead, the vias 612 are adjacent to the magnetic plug 611. The traces 613 pass over and below the magnetic plug 611.

Referring now to Figure 6D, a cross-sectional illustration of the buildup layers 652 and the magnetic plug 611 is shown, in accordance with an embodiment. As shown, an inductive loop is provided around the magnetic plug 611. The vias 612 pass through the buildup layers 652 adjacent to the magnetic plug 611. The traces 613 provide lateral connections between the vias 612, and the traces 613 pass over the magnetic plug 611. In the illustrated embodiment, the traces 613 are in direct contact with the magnetic plug 611 and the buildup layers 652. However, in some embodiments a dielectric layer may be provided between the traces 613 and the magnetic plug 611.

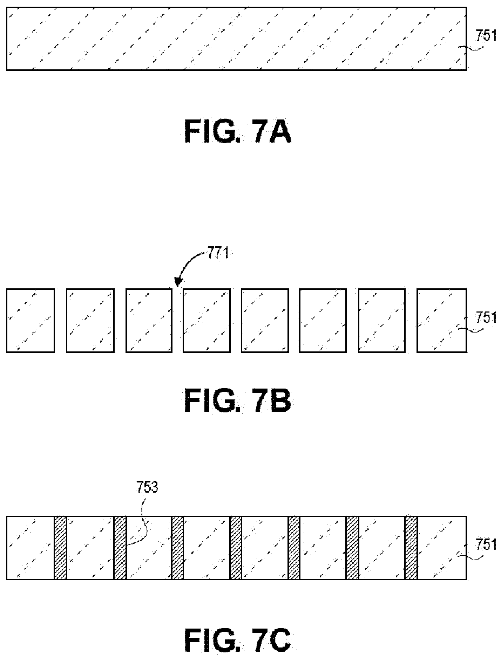

Referring now to Figures 7A-7Q, a series of cross-sectional illustrations depicting a process for forming an electronic package with a glass patch that includes in-built inductors is shown, in accordance with an embodiment. In the illustrated embodiment, a single unit is formed. However, it is to be appreciated that the form factor of the glass patch may be panel level, quarter panel level, or any other form factor. That is, parallel processing of multiple units is possible in some embodiments.

Referring now to Figure 7A, a cross-sectional illustration of a core 751 is shown, in accordance with an embodiment. In an embodiment, the core 751 may comprise glass. That is, core 751 may be a glass core. In an embodiment, the core 751 has a thickness that is approximately 100µm or greater, or approximately 500µm or greater. In an embodiment, a coefficient of thermal expansion (CTE) of the core 751 may be approximately 4 or below.

Referring now to Figure 7B, a cross-sectional illustration of the core 751 after via openings 771 are formed through the core 751 is shown, in accordance with an embodiment. In an embodiment, the via openings 771 may be formed with the use of a crack-free laser-based drilling process. In the illustrated embodiment, the via openings 771 have vertical sidewalls, but it is to be appreciated that the sidewalls may be tapered in some embodiments.

Referring now to Figure 7C, a cross-sectional illustration of the core 751 after the vias 753 are disposed in the via openings 771 is shown, in accordance with an embodiment. In an embodiment, the vias 753 may be deposited with any suitable conductive material deposition and/or plating process. In an embodiment, excess conductive material is polished back so that the vias 753 are substantially flush with top and bottom surfaces of the core 751.

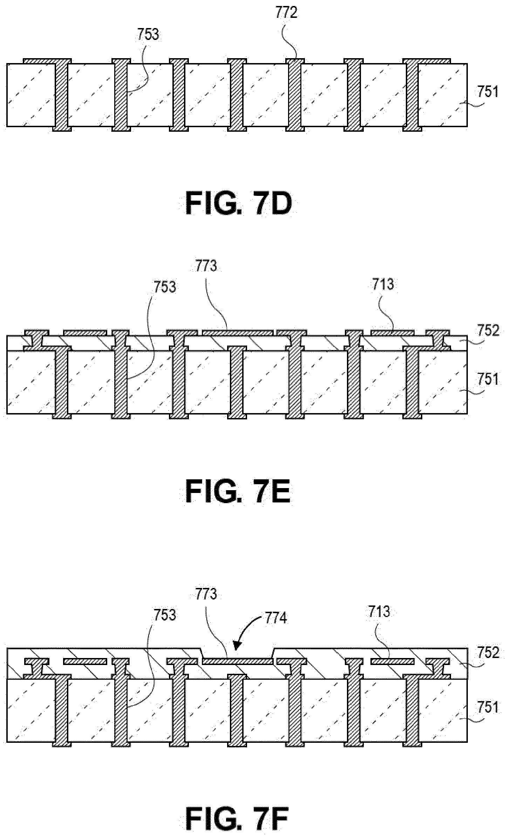

Referring now to Figure 7D, a cross-sectional illustration of the core 751 after conductive pads 772 and traces are formed on the top and bottom surface of the core 751 is shown, in accordance with an embodiment. The pads 772 and traces may be formed with standard SAP techniques in some embodiments.

Referring now to Figure 7E, a cross-sectional illustration of the core 751 after a redistribution layer 752 is formed over the core 751 is shown, in accordance with an embodiment. In an embodiment, the redistribution layer may be formed with a lamination process and a laser drilling process may be used to open the vias. An electroless or sputter seed and SAP process may be used to fill the vias and form the traces/pads. Particularly, in the layer shown, a pad 773 is formed. The bridge die may be placed over the pad 773. Additionally, traces 713 are provided. The traces 713 may be part of the inductor that will surround the subsequently formed magnetic plugs.

Referring now to Figure 7F, a cross-sectional illustration of the core 751 after an additional dielectric layer 752 is laminated and patterned is shown, in accordance with an embodiment. In an embodiment, an opening 774 may be formed to expose the pad 773. For example, a laser drilling process may be used in some embodiments.

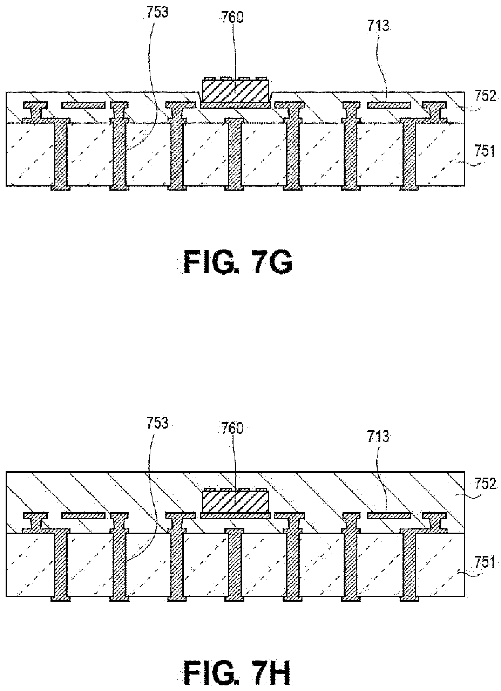

Referring now to Figure 7G, a cross-sectional illustration of the core 751 after a bridge die 760 is attached to the pad 773 is shown, in accordance with an embodiment. In an embodiment, the bridge die 760 is attached with a die attach film (DAF) (not shown) or the like.

Referring now to Figure 7H, a cross-sectional illustration of the core 751 after an additional dielectric buildup layer 752 is laminated over the bridge die 760 is shown, in accordance with an embodiment. At this point, the bridge die 760 is entirely embedded within the buildup layer 752.

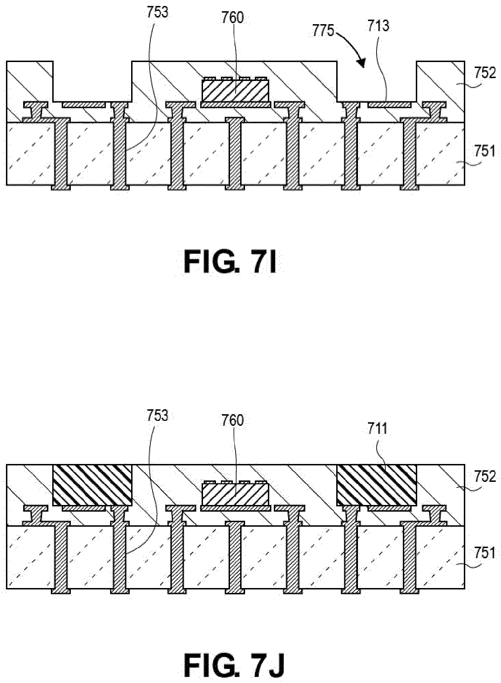

Referring now to Figure 7I, a cross-sectional illustration of the core 751 after cavities 775 are formed into the buildup layers 752 is shown, in accordance with an embodiment. In an embodiment, the cavities 775 extend to a depth suitable for exposing the conductive traces 713. In an embodiment, the cavities 775 may be formed with a laser drilling process. In the illustrated embodiment, the sidewalls 775 of the cavities are substantially vertical. In other embodiments, the sidewalls 775 may be tapered.

Referring now to Figure 7J, a cross-sectional illustration of the core 751 after magnetic plugs 711 are disposed in the cavities 775 is shown, in accordance with an embodiment. In an embodiment, a high permeability magnetic dielectric paste is squeeze printed to fill the cavities 775. In other embodiments, a magnetic film may be used to fill the cavities 775. In an embodiment, excess magnetic paste is polished back so that the magnetic plug 711 is substantially flush with the top of the buildup layers 752. In some embodiments, the magnetic material is cured. If the magnetic material shrinks during the cure, then a two-step squeeze printing process may be used to ensure that the cavities 775 are fully filled by the magnetic plugs 711.

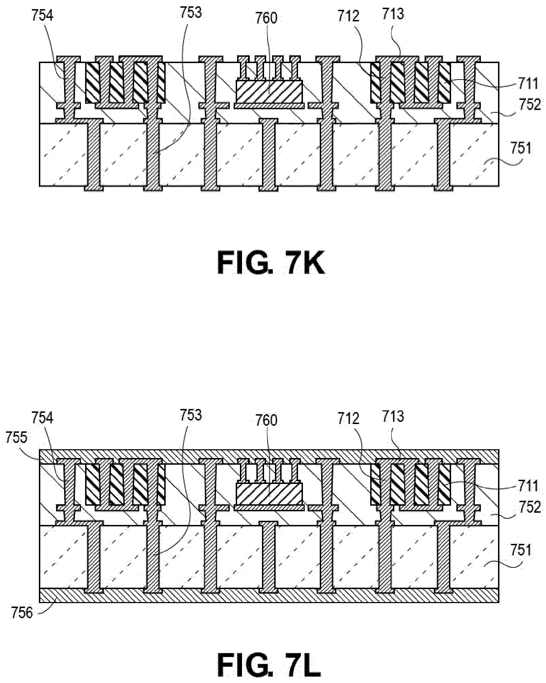

Referring now to Figure 7K, a cross-sectional illustration of the core 751 after vias 754 and 712 are formed through the buildup layers 752 and the magnetic plugs 711 is shown, in accordance with an embodiment. In an embodiment, the vias 754 and the vias 712 may be formed with a laser drilling process. In an embodiment, fine pitch vias may also be formed over the bridge die 760. The vias 712 through the magnetic plugs 711 are coupled together by traces 713 above and below the magnetic plugs 711 in order to form conductive loops for in-built inductors. The in-built inductors may be substantially similar to the inductors described above with respect to Figures 6A-6D.

Referring now to Figure 7L, a cross-sectional illustration of the core 751 after solder resist 755 and 756 is applied to the top and bottom surfaces is shown, in accordance with an embodiment. In an embodiment, the solder resist 755 and 756 may be applied with a lamination process.

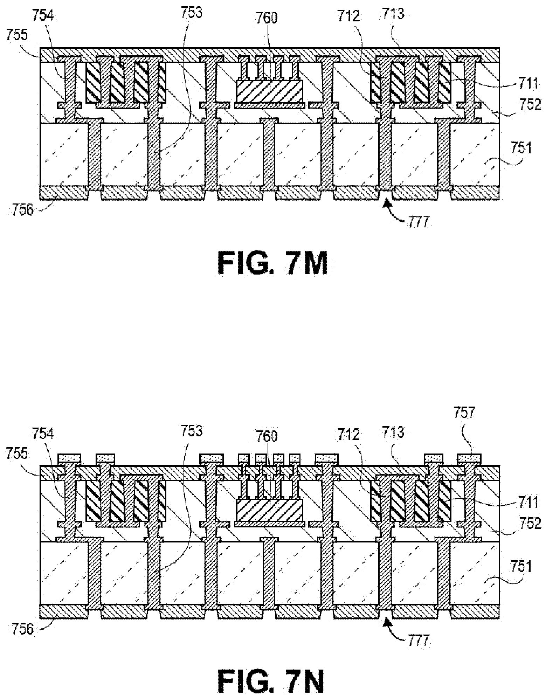

Referring now to Figure 7M, a cross-sectional illustration of the core 751 after solder resist openings 777 are formed through the bottom solder resist 756 is shown, in accordance with an embodiment. In an embodiment, the solder resist openings 777 may be formed with an exposure and develop process, or the like. In an embodiment, the pads exposed by the solder resist openings 777 may be plated with a surface finish (not shown). In an embodiment, the surface finish may be an electroless surface finish, such as an electroless surface finish comprising nickel.

Referring now to Figure 7N, a cross-sectional illustration of the core 751 after FLIs are formed through the top solder resist 755 is shown, in accordance with an embodiment. In an embodiment, the vias and pads may be formed with a lithography process. The fine pitch vias and pads over the bridge die 760 may be formed with a laser process. The pads may include a surface finish. A solder 757 may be disposed over the pads as well.

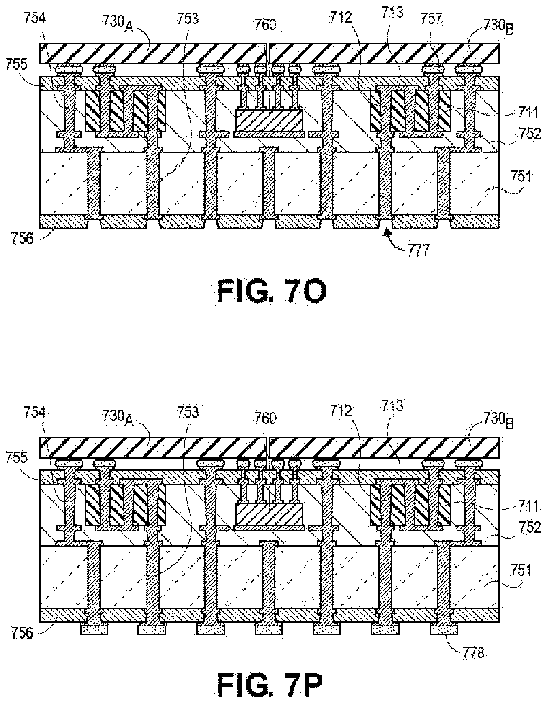

Referring now to Figure 7O, a cross-sectional illustration of the core 751 after dies 730_{A} and 730_{B} are attached to the solder 757 on the FLI pads is shown, in accordance with an embodiment. As shown, the first die 730₄ may be communicatively coupled to the second die 730_{B} through the bridge die 760. The dies 730_{A} and 730_{B} may be bonded to the FLI pads with a TCB process or the like. In addition to bonding the dies 730, an underfill (not shown) may surround the solder 757. A mold layer (not shown) may be disposed around the first die 730_{A} and the second die 730_{B}.

Referring now to Figure 7P, a cross-sectional illustration of the core 751 after MLI pads are formed on the backside of the core 751 is shown, in accordance with an embodiment. In an embodiment, conductive material is disposed in the solder resist openings 777 and MLI pads are formed with a traditional SAP process. In some embodiments, solder 778 is plated over the MLI pads.

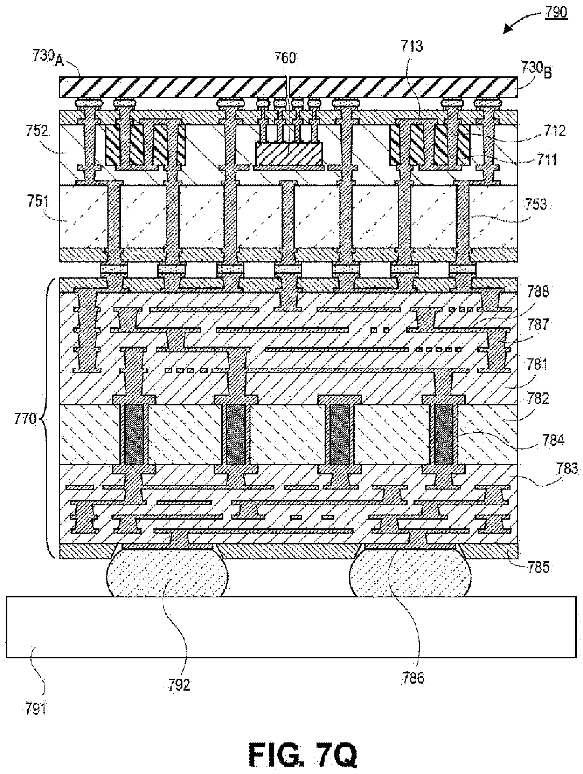

Referring now to Figure 7Q, a cross-sectional illustration of the core 751 after the MLI pads are coupled to a package substrate 770 is shown, in accordance with an embodiment. In an embodiment, the package substrate 770 may be coupled to a board 791 by SLIs 792. The structure shown in Figure 7Q may be referred to as an electronic system 790.

In an embodiment, the package substrate 770 may be a typical package substrate. In some embodiments, the package substrate 770 comprises a core 782. The core 782 may be an organic core in some embodiments. Through core vias 784 may be provided through the core 782. The through core vias 784 may be plated through holes or the like. In an embodiment, buildup layers 781 are over the core 782, and buildup layers 783 may be below the core 782. Pads/traces 788 and vias 787 provide electrical routing in the buildup layers 781 and 783. SLI pads 786 may be exposed through a solder resist 785 at the bottom of the package substrate 770. The SLI pads 786 may be coupled to the board 791 by the SLIs 792.

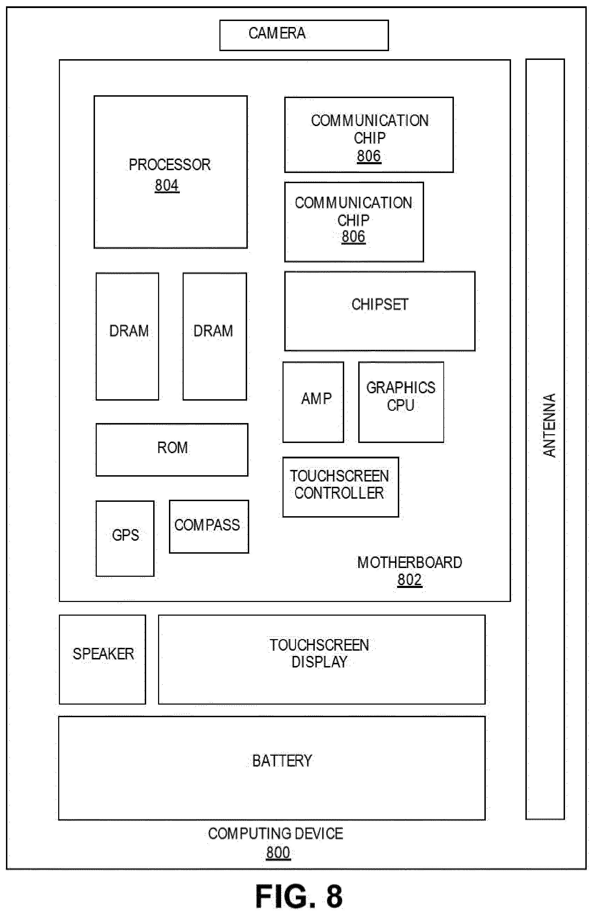

Figure 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor may be part of an electronic package that comprises an in-built inductor that is provided in a glass core, or in the buildup layers of a glass patch, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip may be part of an electronic package that comprises an in-built inductor that is provided in a glass core, or in the buildup layers of a glass patch, in accordance with embodiments described herein.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

## Claims

1. An electronic package (550), comprising:
a core (551), wherein the core (551) comprises glass;
buildup layers (552) over the core (551);
a plug (511) embedded in the buildup layers (552), wherein the plug (511) comprises a magnetic material;
an inductor wrapping around the plug (511)
a solder resist layer (556) under the core (551) and directly in contact with the core (551), wherein pads (589) are provided on the solder resist layer.

2. The electronic package of claim 1, wherein the inductor comprises vias that pass through the plug, wherein the vias are coupled together by traces over the plug.

3. The electronic package of claim 2, wherein the vias have a taper, wherein an end closer to the core is narrower than an end away from the core.

4. The electronic package of claim 1, 2 or 3, wherein the inductor comprises vias that are adjacent to the plug, wherein the vias are coupled together by traces over the plug.

5. The electronic package of claim 1, 2, 3 or 4, further comprising:
a bridge embedded in the buildup layers, wherein the bridge is adjacent to the plug.

6. The electronic package of claim 5, wherein the bridge comprises through silicon vias.

7. The electronic package of claim 5 or 6, further comprising:
a first die over the buildup layers; and
a second die over the buildup layers, wherein the bridge communicatively couples the first die to the second die.

8. The electronic package of claim 1, 2, 3, 4, 5, 6 or 7, wherein the inductor is coupled to a via through the core.

9. The electronic package of any one of the preceding claims, wherein the pads are coupled to a package substrate with an organic core.

10. A method of forming a package substrate, comprising:
forming openings through a first layer, wherein the first layer comprises glass;
disposing vias into the openings;
forming second layers over the first layer, wherein the second layers comprise a dielectric material;
forming a cavity into the second layers;
disposing a plug in the cavity, wherein the plug comprises a magnetic material;
forming an inductor around the plug; and
forming a solder resist layer under the core and directly in contact with the core, wherein pads are provided on the solder resist layer.

11. The method of claim 10, wherein the inductor comprises:
vias that pass through the plug, wherein the vias are coupled together by traces over the plug.

12. The method of claim **11,** wherein the vias have a taper with a narrow end closer to the first layer than a wide end.

13. The method of claim 10, **11** or 12, wherein forming the vias includes forming a via opening with a laser ablation process.

14. The method of claim 10, **11,** 12 or 13, further comprising a bridge embedded in the second layers, wherein the bridge is adjacent to the plug.

## Patentansprüche

1. Elektronikgehäuse (550), das Folgendes umfasst:
einen Kern (551), wobei der Kern (551) Glas umfasst;
Aufbauschichten (552) über dem Kern (551);
einen Stopfen (511), der in die Aufbauschichten (552) eingebettet ist, wobei der Stopfen (511) ein magnetisches Material umfasst;
eine Induktivität, die den Stopfen (511) umschlingt;
eine Lötstopplackschicht (556) unter dem Kern (551) und direkt in Kontakt mit dem Kern (551), wobei Pads (589) auf der Lötstopplackschicht bereitgestellt sind.

2. Elektronikgehäuse nach Anspruch 1, wobei die Induktivität Durchkontaktierungen umfasst, die durch den Stopfen verlaufen, wobei die Durchkontaktierungen durch Leiterbahnen über den Stopfen miteinander gekoppelt sind.

3. Elektronikgehäuse nach Anspruch 2, wobei die Durchkontaktierungen eine Verjüngung aufweisen, wobei ein Ende, das näher an dem Kern liegt, schmaler ist als ein Ende, das von dem Kern entfernt ist.

4. Elektronikgehäuse nach Anspruch 1, 2 oder 3, wobei die Induktivität Durchkontaktierungen umfasst, die an den Stopfen angrenzen, wobei die Durchkontaktierungen durch Leiterbahnen über den Stopfen miteinander gekoppelt sind.

5. Elektronikgehäuse nach Anspruch 1, 2, 3 oder 4, das ferner Folgendes umfasst:
eine Brücke, die in die Aufbauschichten eingebettet ist, wobei die Brücke an den Stopfen angrenzt.

6. Elektronikgehäuse nach Anspruch 5, wobei die Brücke Silizium-Durchkontaktierungen umfasst.

7. Elektronikgehäuse Gehäuse nach Anspruch 5 oder 6, das ferner Folgendes umfasst:
einen ersten Die über den Aufbauschichten; und
einen zweiten Die über den Aufbauschichten, wobei die Brücke den ersten Die mit dem zweiten Die elektrisch koppelt.

8. Elektronikgehäuse nach Anspruch 1, 2, 3, 4, 5, 6 oder 7, wobei die Induktivität durch den Kern mit einer Durchkontaktierung gekoppelt ist.

9. Elektronikgehäuse nach einem der vorhergehenden Ansprüche, wobei die Pads mit einem Gehäusesubstrat mit einem organischen Kern gekoppelt sind.

10. Verfahren zum Bilden eines Gehäusesubstrats, das Folgendes umfasst:
Bilden von Öffnungen durch eine erste Schicht, wobei die erste Schicht Glas umfasst;
Anordnen von Durchkontaktierungen in den Öffnungen;
Bilden zweiter Schichten über der ersten Schicht, wobei die zweiten Schichten ein dielektrisches Material umfassen;
Bilden eines Hohlraums in die zweiten Schichten;
Anordnen eines Stopfens in dem Hohlraum, wobei der Stopfen ein magnetisches Material umfasst;
Bilden einer Induktivität um den Stopfen; und
Bilden einer Lötstopplackschicht unter dem Kern und direkt in Kontakt mit dem Kern, wobei Pads auf der Lötstopplackschicht bereitgestellt sind.

11. Verfahren nach Anspruch 10, wobei die Induktivität Folgendes umfasst:
Durchkontaktierungen, die durch den Stopfen hindurchgehen, wobei die Durchkontaktierungen durch Leiterbahnen über den Stopfen miteinander gekoppelt sind.

12. Verfahren nach Anspruch 11, wobei die Durchkontaktierungen eine Verjüngung mit einem schmalen Ende aufweisen, das näher an der ersten Schicht liegt als ein breites Ende.

13. Verfahren nach Anspruch 10, 11 oder 12, wobei das Bilden der Durchkontaktierungen das Bilden einer Durchkontaktierungsöffnung mit einem Laserablationsprozess beinhaltet.

14. Verfahren nach Anspruch 10, 11, 12 oder 13, das ferner eine Brücke umfasst, die in den zweiten Schichten eingebettet ist, wobei die Brücke an den Stopfen angrenzt.

## Revendications

1. Boîtier électronique (550) comprenant :
un cœur (551), le cœur (551) comprenant du verre ;
des couches de superposition (552) au-dessus du cœur (551) ;
un insert (511) incorporé dans les couches de superposition (552), l'insert (511) comprenant un matériau magnétique ;
une inductance enroulée autour de l'insert (511)
une couche de réserve de soudure (556) sous le cœur (551) et directement en contact avec le cœur (551), où des plages de connexion (589) sont pourvues sur la couche de réserve de soudure.

2. Boîtier électronique selon la revendication 1, dans lequel l'inductance comprend des trous d'interconnexion qui passent à travers l'insert, où les trous d'interconnexion sont couplés ensemble par des traces sur l'insert.

3. Boîtier électronique selon la revendication 2, dans lequel les trous d'interconnexion ont une forme conique, où une extrémité plus proche du cœur est plus étroite qu'une extrémité éloignée du cœur.

4. Boîtier électronique selon les revendications 1, 2 ou 3, dans lequel l'inductance comprend des trous d'interconnexion qui sont adjacents à l'insert, où les trous d'interconnexion sont couplés ensemble par des traces sur l'insert.

5. Boîtier électronique selon les revendications 1, 2, 3, ou 4, comprenant en outre :
un pont incorporé dans les couches de superposition, le pont étant adjacent à l'insert.

6. Boîtier électronique selon la revendication 5, dans lequel le pont comprend des trous d'interconnexion en silicium.

7. Boîtier électronique selon les revendications 5 ou 6, comprenant en outre :
une première puce au-dessus des couches de superposition ; et
une deuxième puce au-dessus des couches de superposition, le pont assurant une liaison de communication entre la première puce et la deuxième puce.

8. Boîtier électronique selon les revendications 1, 2, 3, 4, 5, 6 ou 7, dans lequel l'inductance est couplée à un trou d'interconnexion traversant le cœur.

9. Boîtier électronique selon l'une quelconque des revendications précédentes, dans lequel les plots sont couplés à un substrat de boîtier avec un cœur organique.

10. Procédé de formation d'un substrat de boîtier, le procédé comprenant les étapes suivantes :
former des ouvertures à travers une première couche, la première couche comprenant du verre ;
disposer des trous d'interconnexion dans les ouvertures ;
former des deuxièmes couches sur la première couche, les deuxièmes couches comprenant un matériau diélectrique ;
former une cavité dans les deuxièmes couches ;
disposer un insert dans la cavité, l'insert comprenant un matériau magnétique ;
former une inductance autour de l'insert ; et
former une couche de réserve de soudure sous le cœur et directement en contact avec le cœur, où des plages de connexion sont pourvues sur la couche de réserve de soudure.

11. Procédé selon la revendication 10, dans lequel l'inductance comprend :
des trous d'interconnexion qui traversent l'insert, où les trous d'interconnexion sont couplés entre eux par des traces sur l'insert.

12. Procédé selon la revendication 11, dans lequel les trous d'interconnexion ont une forme conique ayant dont l'extrémité étroite est plus proche de la première couche que l'extrémité large.

13. Procédé selon les revendications 10, 11 ou 12, dans lequel la formation des trous d'interconnexion comprend la formation d'une ouverture de trou d'interconnexion avec un procédé d'ablation au laser.

14. Procédé selon les revendication 10, 11, 12 ou 13, comprenant en outre un pont incorporé dans les deuxièmes couches, où le pont est adjacent à l'insert.
